# EUROPÄISCHE PATENTANMELDUNG

(11) **EP 3 749 076 A1**
(43) Veröffentlichungstag der Anmeldung: **09.12.2020**
(21) Anmeldenummer: 20177495.7
(22) Anmeldetag: 29.05.2020
(51) Int. Cl.: H05K 7/20, G01K 3/14

(54) **VERFAHREN ZUM ÜBERWACHEN EINER KÜHLWIRKUNG EINER LUFTKÜHLVORRICHTUNG**

(30) Priorität: 08.06.2019 DE 102019004070
(71) Anmelder: Diehl AKO Stiftung & Co. KG, 88239 Wangen (DE)
(72) Erfinder: Bihler, Simon, 88239 Wangen (DE)
(74) Vertreter: Diehl Patentabteilung

(57) **Zusammenfassung**

Bei einer elektronischen Anordnung mit einer Elektronikbaugruppe (10), die ein Wärme erzeugendes elektrisches Bauteil (14) enthält, und einer Luftkühlvorrichtung (18) zum Kühlen des elektrischen Bauteils (14), die einen mit dem Bauteil (14) thermisch gekoppelten Kühlkörper (19) und einen Lüfter (20) zum Erzeugen eines Kühlluftstroms über/ durch den Kühlkörper (19) enthält, kann eine Kühlwirkung der Luftkühlvorrichtung (18) für das elektrische Bauteil (14) basierend auf einer Bauteiltemperatur (TB), einer Umgebungstemperatur (TU) und einem Betriebszustand der Elektronikbaugruppe (10) ermittelt werden.

## Beschreibung

Die vorliegende Erfindung betrifft ein Verfahren zum Überwachen einer Kühlwirkung einer Luftkühlvorrichtung zum Kühlen eines elektrischen Bauteils einer Elektronikbaugruppe sowie eine ein solches Verfahren umsetzende elektronische Anordnung mit einer Elektronikbaugruppe und einer Luftkühlvorrichtung. Das Überwachungsverfahren ist insbesondere für Antriebsschaltungen zum Antreiben eines elektronisch kommutierten Motors, bei denen die Wärme des Wechselrichters durch eine eigene Luftkühlvorrichtung abgeführt wird, geeignet.

Zur Kühlung elektronischer Komponenten werden häufig Kühlkörper mit zusätzlichem Lüfter eingesetzt, um die Kühlleistung im Vergleich zur passiven Kühlung (freie Konvektion) zu erhöhen. Im Stand der Technik sind verschiedene Verfahren zum Regeln der erforderlichen Kühlleistung sowie Schutzeinrichtungen für die zu kühlenden Bauteile bei unzureichender Kühlung bekannt. Für die Regelung der Kühlleistung der Luftkühlvorrichtung werden zum Beispiel die Drehzahl des Lüfters, der vom Lüfter erzeugte Luftstrom oder die Temperatur des zu kühlenden Bauteils überwacht. Die DE 102 06 608 A1 offenbart eine Temperaturüberwachung für Mikroprozessor-Kühleinrichtungen, bei der eine Drehzahl des Elektromotors der Ventilatoreinrichtung in Abhängigkeit von einer Temperatur des Mikroprozessors geregelt wird, die durch einen Temperatursensor im Kühlkörper des Mikroprozessors erfasst wird. Die WO 2004/051090 A1 offenbart eine Vorrichtung zum Erzeugen eines Luftstroms zum Kühlen von elektrischen Bauteilen, die einen zusätzlichen Luftstromwächter im Luftstrom aufweist, um den Lüftungsprozess zu überwachen.

Als Schutzeinrichtung werden zum Beispiel Temperatursensoren zum Erfassen der Bauteiltemperatur eingesetzt, um bei einer Überhitzung des elektrischen Bauteils die Elektronikbaugruppe abzuschalten. Üblicherweise wird bei Erreichen eines festgelegten Temperaturlimits die Leistung des Bauteils bzw. der Elektronikbaugruppe reduziert oder die Elektronikbaugruppe komplett abgeschaltet, um das Bauteil zu schützen. In vielen Applikation, in denen Wechselrichter für die Ansteuerung von Motoren verwendet werden, wie beispielsweise bei Wärmepumpen, Kühlgeräten, Schaltschränken usw., wird die Regelung des Gesamtsystems häufig von einer übergeordneten Hauptsteuerung, welche die Solldrehzahl des Motors bestimmt, die der Wechselrichter entsprechend umsetzen soll, durchgeführt. Wird nun die Kühlleistung stark verringert, kann die Drehzahl reduziert oder der Motor komplett abgeschaltet werden, wodurch die Hauptsteuerung die gesamte Applikation außer Betrieb setzt. Ein Nachteil derartiger herkömmlicher Elektronikbaugruppen mit Luftkühlvorrichtung besteht darin, dass die Applikation unerwartet nurmehr mit verringerter Leistung betrieben werden kann oder komplett abgeschaltet werden muss, falls eine Leistungsreduzierung nicht möglich ist, was normalerweise einen unverzüglichen Service-Einsatz erfordert.

Es ist die Aufgabe der Erfindung, ein verbessertes Überwachungssystem für eine Luftkühlvorrichtung zum Kühlen eines elektrischen Bauteils einer Elektronikbaugruppe zu schaffen, mit dem auf einfache Weise eine frühzeitige Erkennung einer sich verringernden Kühlwirkung möglich ist.

Diese Aufgabe wird gelöst durch ein Überwachungsverfahren mit den Merkmalen des Anspruchs 1. Besonders vorteilhafte Ausgestaltungen und Weiterbildungen der Erfindung sind Gegenstand der abhängigen Ansprüche.

Das erfindungsgemäße Verfahren zum Überwachen einer Kühlwirkung einer Luftkühlvorrichtung zum Kühlen eines elektrischen Bauteils einer Elektronikbaugruppe, wobei die Luftkühlvorrichtung einen mit dem elektrischen Bauteil thermisch gekoppelten Kühlkörper und einen Lüfter zum Erzeugen eines Luftstroms über/durch den Kühlkörper enthält, weist die Schritte des Erfassens einer Bauteiltemperatur des elektrischen Bauteils; des Erfassens einer Umgebungstemperatur einer Umgebung der Elektronikbaugruppe; und des Ermittelns einer Kühlwirkung der Luftkühlvorrichtung für das elektrische Bauteil basierend auf der erfassten Bauteiltemperatur, der erfassten Umgebungstemperatur und eines Betriebszustandes der Elektronikbaugruppe auf.

Im Gegensatz zu den eingangs beschriebenen herkömmlichen Systemen mit einer Überwachung und Regelung der Kühlleistung des Lüfters oder einer Temperaturüberwachung des zu kühlenden Bauteils für eine Abschaltung der Elektronikbaugruppe bei Überschreiten eines Temperaturlimits wird gemäß der Erfindung vorgeschlagen, die tatsächliche Kühlwirkung der Kühlvorrichtung für das elektrische Bauteil zu überwachen, um so frühzeitig eine sich verringernde Kühlwirkung zu erkennen und ggf. frühzeitig (d.h. bei noch ausreichender Kühlwirkung) Gegenmaßnahmen gegen eine mögliche Überhitzung des elektrisch Bauteils veranlassen zu können. Die erfindungsgemäße Lösung beruht insbesondere auf den nachfolgend erläuterten Erkenntnissen des Erfinders.

Um die Kosten gering zu halten, werden häufig einfache drehzahlkonstante Lüfter verwendet, welche mit Gleichspannung betrieben werden und kein Feedback über die tatsächliche Drehzahl zur Verfügung stellen. Durch Fehler in dieser Gleichspannungsversorgung, beispielsweise durch einen erhöhten Kontaktwiderstand am Stecker, können sich die Drehzahl und damit die Kühlleistung verringern. Dies kann auch hervorgerufen werden durch Verschmutzung des Lüfters, des Kühlkörpers oder vorhandener Luftfilter. Die Kühlleistung hängt außerdem vom Wärmeübergang zwischen dem elektrischen Bauteil und dem Kühlkörper ab, welcher sich über die Lebensdauer je nach eingesetzten Materialien verändern kann. Diese Änderungen in der Kühlanordnung können über einen längeren Zeitraum dazu führen, dass die Kühlwirkung so stark abnimmt, dass die zu kühlende elektrischen Bauteile überhitzen und ausfallen.

In den Applikationen finden sich in der Regel über einen längeren Zeitraum hinweg immer wiederkehrende Betriebspunkte der Elektronikbaugruppe. Bei gleichen Betriebspunkten mit gleicher Leistung der Elektronikbaugruppe und somit gleicher abzuführender Verlustleistung bzw. Verlustwärme des elektrischen Bauteils ergibt sich im eingeschwungenen Betriebszustand je nach Kühlwirkung der Kühlvorrichtungsanordnung immer ein definierter Temperaturunterschied zwischen dem zu kühlenden Bauteil und der Umgebung der Elektronikbaugruppe. Bei einer reduzierten Kühlwirkung der Kühlvorrichtungsanordnung aus irgendeinem Grund wie zum Beispiel einer Verschmutzung im Bereich des Lüfters und/oder einer Verschlechterung des Wärmeübergangs zwischen Kühlkörper und elektrischem Bauteil, die im Laufe der Lebensdauer auftreten kann, verändern sich diese Temperaturunterschiede bei den verschiedenen Betriebszuständen. Durch eine Überwachung der Bauteiltemperatur und der Umgebungstemperatur kann so in Abhängigkeit von den Betriebszuständen der Elektronikbaugruppe zu den Zeiten der Temperaturmessungen eine Verringerung der Kühlwirkung für das elektrische Bauteil erkannt werden, selbst wenn die eigentliche Kühlleistung der Luftkühlvorrichtung (d.h. z.B. Lüfterdrehzahl und Luftstrom) unverändert sind. D.h. gemäß der Erfindung werden auch andere Einflüsse als nur der Luftstrom, welche zu einer Reduzierung der Kühlwirkung führen können, beim Ermitteln der Kühlwirkung mit einbezogen bzw. berücksichtigt.

Durch das frühzeitige Erkennen einer Reduzierung der Kühlwirkung können dann ggf. Gegenmaßnahmen wie zum Bespiel Wartungsarbeiten zum Beseitigen von Verschmutzung des Lüfters und des Kühlkörpers oder Reparieren der Wärmekopplung zwischen Kühlkörper und zu kühlendem Bauteil durchgeführt werden. Auf diese Weise kann ein unerwarteter Ausfall der Elektronikbaugruppe und zum Beispiel des angeschlossenen Motors zu einem späteren Zeitpunkt, wenn das zu kühlende Bauteil aufgrund einer weiteren Reduzierung der Kühlwirkung überhitzt, vermieden werden.

Das erfindungsgemäße Verfahren benötigt lediglich das Erfassen der Bauteiltemperatur und der Umgebungstemperatur sowie den der Steuerung ohnehin bekannten Betriebszustand der Elektronikbaugruppe. Das erfindungsgemäße Verfahren kann so auf einfache Weise und ohne zusätzliche Komponenten wie beispielsweise Luftstromwächter umgesetzt werden.

Das Erfassen der Bauteiltemperatur erfolgt vorzugsweise durch einen ersten Temperatursensor am oder im elektrischen Bauteil oder am Kühlkörper der Luftkühlvorrichtung.

Das Erfassen der Umgebungstemperatur erfolgt vorzugsweise durch einen zweiten Temperatursensor an der Elektronikbaugruppe oder durch eine mit der Steuerung verbundene Einrichtung.

Der Betriebszustand der Elektronikbaugruppe ist der Steuerung in der Regel ohnehin bekannt, da diese die Elektronikbaugruppe ansteuert und regelt.

In einer Ausgestaltung der Erfindung weist das Verfahren ferner ein Bestimmen einer Temperaturdifferenz zwischen der erfassten Bauteiltemperatur und der erfassten Umgebungstemperatur auf und wird die Kühlwirkung der Luftkühlvorrichtung basierend auf der bestimmten Temperaturdifferenz während eines stabilen Betriebszustandes der Elektronikbaugruppe ermittelt. Vorzugsweise werden die Bauteiltemperatur und die Umgebungstemperatur nach einer ersten vorbestimmten Zeitdauer nach einem Einschalten der Elektronikbaugruppe erfasst. Mit anderen Worten handelt es sich bei dem stabilen Betriebszustand um einen eingeschwungenen Betriebszustand der Elektronikbaugruppe nach deren Einschalten.

In einer anderen Ausgestaltung der Erfindung weist das Verfahren ferner ein Bestimmen eines Temperaturgradienten der erfassten Bauteiltemperatur auf und wird die Kühlwirkung der Luftkühlvorrichtung basierend auf dem bestimmten Temperaturgradienten bei einem Lastsprung wie zum Beispiel während eines Betriebsstartvorganges der Elektronikbaugruppe ermittelt. Vorzugsweise werden die Bauteiltemperatur und die Umgebungstemperatur vor einer zweiten vorbestimmten Zeitdauer nach dem Lastsprung der Elektronikbaugruppe erfasst. Mit anderen Worten wird der Temperaturgradient vorzugsweise kurz nach einem Lastsprung wie dem Einschalten der Elektronikbaugruppe erfasst und ausgewertet, da zu diesem Zeitpunkt je nach Kühlwirkung der Luftkühlvorrichtung markante Unterschiede erkennbar sind. Diese Ausgestaltung hat zudem den Vorteil, dass zur Erfassung der Temperaturwerte und Ermittlung der Kühlwirkung nur eine vergleichsweise kurze Zeit benötigt wird. Die zweite vorbestimmte Zeitdauer ist vorzugsweise kleiner als die oben genannte erste vorbestimmte Zeitdauer.

In einer Ausgestaltung der Erfindung werden die bestimmte Temperaturdifferenz oder der bestimmte Temperaturgradient mit gespeicherten Kennlinien verglichen. Die Kennlinien werden zuvor ermittelt und abgespeichert. Die Ermittlung der Kühlwirkung erfolgt dann basierend auf der Abweichung der aktuellen Messwerte von den Kennlinienwerten. Ein Grenzwert für diese Abweichung ist vorzugsweise so gewählt, dass noch keine Leistungsreduzierung der Elektronikbaugruppe wegen einer Bauteilüberhitzung erforderlich ist, aber erkennbar ist, dass die Kühlwirkung der Luftkühlvorrichtung merklich abgenommen hat.

In einer Ausgestaltung der Erfindung werden die Bauteiltemperatur, die Umgebungstemperatur, die Temperaturdifferenz und/oder der Temperaturgradient über mehrere Messungen hinweg gemittelt oder gefiltert, um einzelne Fehlmessungen kompensieren bzw. löschen zu können.

In einer Ausgestaltung der Erfindung kann beim Ermitteln der Kühlwirkung der Luftkühlvorrichtung auch zwischen einer reduzierten Kühlwirkung und einer unzureichenden Kühlwirkung differenziert werden.

Gegenstand der Erfindung ist auch eine elektronische Anordnung mit einer Elektronikbaugruppe, die ein Wärme erzeugendes elektrisches Bauteil enthält, und einer Luftkühlvorrichtung zum Kühlen des elektrischen Bauteils, die einen mit dem Bauteil thermisch gekoppelten Kühlkörper und einen Lüfter zum Erzeugen eines Kühlluftstroms über den Kühlkörper enthält, die ferner aufweist: einen ersten Temperatursensor zum Erfassen einer Bauteiltemperatur des elektrischen Bauteils; eine Einrichtung zum Erfassen einer Umgebungstemperatur einer Umgebung der Elektronikbaugruppe; und eine Steuerung zum Ansteuern der Elektronikbaugruppe und Ermitteln einer Kühlwirkung der Luftkühlvorrichtung für das elektrische Bauteil basierend auf der erfassten Bauteiltemperatur, der erfassten Umgebungstemperatur und eines Betriebszustandes der Elektronikbaugruppe. Die Steuerung ist vorzugsweise zum Ausführen des oben beschriebenen Verfahrens der Erfindung ausgestaltet.

In einer Ausgestaltung der Erfindung weist die Steuerung einen Timer zum Erfassen einer Zeitdauer nach einem Einschalten der Elektronikbaugruppe auf.

In einer Ausgestaltung der Erfindung weist die Steuerung einen Speicher zum Speichern von Kennlinien für die Temperaturdifferenz und/oder Kennlinien für den Temperaturgradienten auf.

Die Steuerung der elektronischen Anordnung ist vorzugsweise eine zentrale Hauptsteuerung für zum Beispiel ein Gerät mit dem durch die Antriebsschaltung angetriebenen Motor. Die Baugruppensteuerung zum Ansteuern der Elektronikbaugruppe wie zum Beispiel die Antriebssteuerung ist vorzugsweise mit dieser Hauptsteuerung verbunden oder in diese integriert.

Die vorliegende Erfindung ist auf keine speziellen Elektronikbaugruppen oder Luftkühlvorrichtungen beschränkt. Sie ist aber insbesondere für eigenständig luftgekühlte Elektronikbaugruppen, deren Kühlwirkung stark von einer permanent zunehmenden Verschmutzung abhängig ist, in vorteilhafter Weise einsetzbar. Außerdem ist die Erfindung in besonders vorteilhafter Weise für Antriebsschaltungen (Elektronikbaugruppe im Sinne der Erfindung) zum Antreiben elektronisch kommutierter Motoren mit einem Wechselrichter (elektrisches Bauteil im Sinne der Erfindung) einsetzbar, zum Beispiel von Motoren für Kühlgeräte (mit Kompressoren), Wärmepumpen, Schaltschränken und dergleichen.

Obige sowie weitere Merkmale und Vorteile der Erfindung werden aus der nachfolgenden Beschreibung bevorzugter, nicht-einschränkender Ausführungsbeispiele anhand der beiliegenden Zeichnung besser verständlich. Darin zeigen, größtenteils schematisch:
- Fig. 1: ein Blockschaltbild einer elektronischen Anordnung gemäß einem Ausführungsbeispiel der vorliegenden Erfindung;
- Fig. 2: Zeitdiagramme zum Veranschaulichen der Bauteiltemperatur und der Temperaturdifferenz für verschiedene Betriebszustände der Elektronikbaugruppe; und
- Fig. 3: Zeitdiagramme zum Veranschaulichen der Bauteiltemperatur und des Temperaturgradienten für verschiedene Betriebszustände der Elektronikbaugruppe.

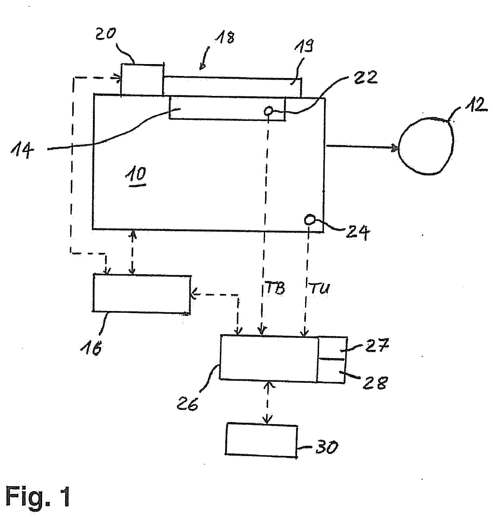

Fig. 1 zeigt beispielhaft eine Ansteuerung für Motoren von zum Beispiel Wärmepumpen, Kühlgeräten, Schaltschränken, etc. als ein Ausführungsbeispiel einer elektronischen Anordnung gemäß der Erfindung.

Die elektronische Anordnung hat eine Antriebsschaltung 10 als Elektronikbaugruppe im Sinne der Erfindung zum Ansteuern eines elektronisch kommutierten Motors 12, die einen Wechselrichter 14 als zu kühlendes elektrisches Bauteil im Sinne der Erfindung enthält. Die Antriebsschaltung 14 ist mit einer Baugruppensteuerung 16 (leitungsgebunden oder drahtlos z.B. per Funk) verbunden, welche die Antriebsschaltung 10 und insbesondere auch deren Wechselrichter 14 ansteuert, um den Motor 12 mit einer gewünschten Drehzahl zu betreiben. Die Baugruppensteuerung 16 schaltet die Antriebssteuerung 10 ein und aus, steuert die Leistungsschalter des Wechselrichters 14 an, überwacht den Betriebszustand der Antriebsschaltung 10, etc.

Die elektronische Anordnung weist ferner eine eigene Luftkühlvorrichtung 18 zum Kühlen des Wechselrichters 14 der Antriebsschaltung 10 auf. Die Luftkühlvorrichtung 18 enthält einen Kühlkörper 19, der mit dem Wechselrichter 14 der Antriebsschaltung 10 thermisch gekoppelt ist, um Wärme von dem Wechselrichter 14 abzuführen. Zur Verstärkung der Kühlleistung weist die Luftkühlvorrichtung 18 außerdem einen Lüfter 20 auf, der einen Kühlluftstrom über/durch den Kühlkörper 19 erzeugt (forcierte Konvektion). Der Lüfter 20 wird ebenfalls von der Baugruppensteuerung 16 angesteuert, insbesondere ein- und ausgeschaltet und drehzahlgeregelt. Die Kühlwirkung der Luftkühlvorrichtung 18 ist im Wesentlichen abhängig von dem durch den Lüfter 20 erzeugten Luftstrom sowie die thermische Kopplung des Wechselrichters 14 am Kühlkörper 19.

Wie in Fig. 1 angedeutet, hat die Anordnung ferner einen ersten Temperatursensor 22 zum Erfassen einer Bauteiltemperatur TB des zu kühlenden Wechselrichters 14. Der erste Temperatursensor ist zum Beispiel am Kühlkörper 19 der Luftkühlvorrichtung 18 oder am/im Wechselrichter 14 bzw. dessen Gehäuse platziert. Die Anordnung hat außerdem einen zweiten Temperatursensor 24 zum Erfassen einer Umgebungstemperatur TU einer Umgebung der Antriebsschaltung 10, der beispielsweise auf einer Leiterplatte oder an einem Gehäuse der Antriebsschaltung 10 montiert ist.

Wie in Fig. 1 dargestellt, ist die Baugruppensteuerung 16 ferner mit einer zentralen Hauptsteuerung 26 des den Motor 12 enthaltenden Geräts verbunden (drahtlos oder leitungsgebunden). Die Hauptsteuerung 26 enthält zum Beispiel einen Prozessor und ist ferner mit einem Timer 27 und einem Speicher 28 versehen. Die Hauptsteuerung 26 gibt die gewünschte Drehzahl des Motors 12 an die Baugruppensteuerung 16, damit diese die Antriebssteuerung 10 entsprechend ansteuert. Die Baugruppensteuerung 16 gibt an die Hauptsteuerung 26 entsprechende Rückmeldungen über den Betriebszustand der Antriebsschaltung 10.

Die Hauptsteuerung 26 überwacht außerdem die Kühlwirkung der Luftkühlvorrichtung 18 für den Wechselrichter 14. Zu diesem Zweck senden die Temperatursensoren 22, 24 ihre Temperaturmesswerte TB, TU (in diesem Ausführungsbeispiel) direkt oder alternativ über die Baugruppensteuerung 16 an die Hauptsteuerung 26. Die Umgebungstemperatur TU kann alternativ auch von der Hauptsteuerung 26 selbst mittels anderer Einrichtungen erfasst werden.

In einer alternativen Ausführungsform der Erfindung kann die Baugruppensteuerung 16 auch in die Hauptsteuerung 26 integriert sein. Mit anderen Worten kann die elektronische Anordnung auch nur eine Steuerung für alle Funktionen haben.

Wie in Fig. 1 angedeutet, ist die Hauptsteuerung 26 ferner bevorzugt zur Kommunikation mit einem Benutzer oder mit anderen Geräten, Netzen, etc. mit einer Eingabe/Ausgabevorrichtung 30 verbunden. Die Eingabe/Ausgabevorrichtung 30 hat zum Beispiel ein Display, einen Lautsprecher, eine Bedienvorrichtung, etc.

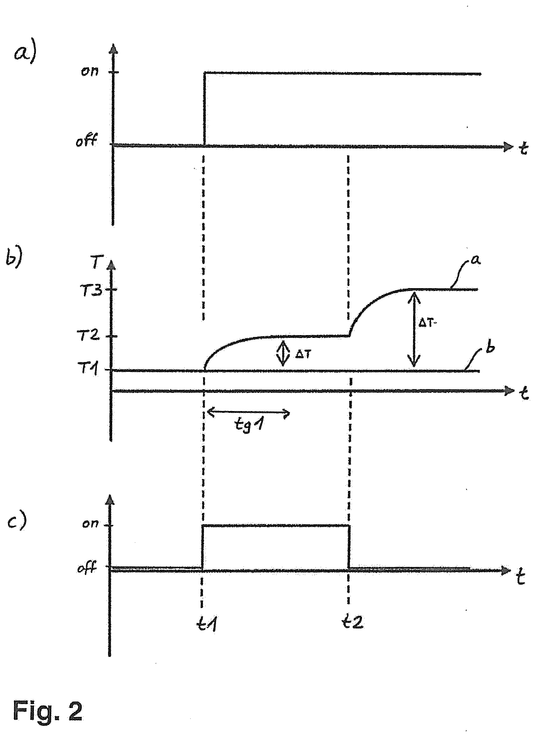

Fig. 2 zeigt mehrere Zeitdiagramme zum Veranschaulichen der Bauteiltemperatur TB und einer Temperaturdifferenz ΔT=TB-TU für verschiedene Betriebszustände der Antriebsschaltung 10.

Die Teilfigur 2a zeigt beispielhaft einen zeitlichen Verlauf des Betriebszustands der Antriebsschaltung 10. Zu einem Zeitpunkt t1 wird die Antriebsschaltung 10 durch die Baugruppensteuerung 16 eingeschaltet.

Die Teilfigur 2c zeigt beispielhaft einen zeitlichen Verlauf des Betriebszustands des Lüfters 20 der Luftkühlvorrichtung 18. Zum Zeitpunkt t1, d.h. zeitgleich zur Antriebsschaltung 10, wird der Lüfter 20 durch die Baugruppensteuerung 16 eingeschaltet. Zu einem späteren Zeitpunkt t2, zu dem sich die Antriebsschaltung 10 bereits in einem stabilen bzw. eingeschwungenen Betriebszustand befindet, wird der Lüfter 20 wieder ausgeschaltet, um die Folgen einer fehlenden oder reduzierten Kühlwirkung der Luftkühlvorrichtung 18 bei einem weiteren Betrieb der Antriebsschaltung 10 zu veranschaulichen.

Die Teilfigur 2b zeigt beispielhaft einen zeitlichen Verlauf der Bauteiltemperatur TB (Kurve a) und der Umgebungstemperatur TU (Kurve b). Die Umgebungstemperatur TU ist unabhängig von den Betriebszuständen der Antriebsschaltung 10 und des Lüfters 20 im Wesentlichen konstant. Solange die Antriebsschaltung 10 und der Lüfter 20 außer Betrieb sind, hat die Bauteiltemperatur TB im Wesentlichen den gleichen Temperaturwert T1 wie die Umgebungstemperatur TU. Nach dem Einschalten der Antriebsschaltung 10 und des Lüfters 20 zum Zeitpunkt t1 steigt die Bauteiltemperatur TB durch Verlustleistungen des Wechselrichters etwas an und pegelt sich nach kurzer Zeit auf einen im Wesentlichen konstanten Temperaturwert T2 ein. Nach dem Ausschalten (oder einem Ausfall) des Lüfters 20 zum Zeitpunkt t2 steigt die Bauteiltemperatur TB aufgrund der fehlenden Kühlwirkung der Luftkühlvorrichtung 18 sofort weiter an und pegelt sich dann auf einen im Wesentlichen konstanten höheren Temperaturwert T3 ein. Dementsprechend steigt auch der Wert der Temperaturdifferenz ΔT zwischen der Bauteiltemperatur TB und der Umgebungstemperatur TU (ΔT=TB-TU) an, wie in Teilfigur 2b gekennzeichnet.

Basierend auf dieser Erkenntnis des Temperaturverhaltens kann die Hauptsteuerung 26 die Kühlwirkung der Luftkühlvorrichtung 18 für den Wechselrichter 14 überwachen. Hierzu werden die Umgebungstemperatur TU und die Bauteiltemperatur TB nach einer ersten vorbestimmten Zeitdauer tg1 nach dem Zeitpunkt t1 des Einschaltens der Antriebsschaltung 10 und des Lüfters 20, d.h. nach Erreichen eines stabilen bzw. eingeschwungenen Betriebszustandes der Antriebsschaltung 10 erfasst. Aus den beiden erfassten Temperaturwerten TB, TU wird dann die Temperaturdifferent ΔT=TB-TU bestimmt und mit einer zuvor ermittelten, im Speicher 28 hinterlegten Kennlinie verglichen. Überschreitet die Abweichung zwischen der aktuellen Temperaturdifferenz ΔT und dem Kennlinienwert für den gleichen Betriebszustand einen vorgegebenen ersten Grenzwert, erkennt die Hauptsteuerung 26, dass die Kühlwirkung der Luftkühlvorrichtung 18 für den Wechselrichter 14 zwar noch ausreicht, d.h. noch keine Überhitzung des Wechselrichters 14 bzw. seiner Leistungsschalter stattfindet, aber die Kühlwirkung merklich reduziert ist. Die Hauptsteuerung 26 gibt dann ein entsprechendes Warnsignal an die Eingabe/Ausgabevorrichtung 30, um einen entsprechenden Wartungsvorgang einleiten zu lassen. Überschreitet die Abweichung zwischen der aktuellen Temperaturdifferenz ΔT und dem Kennlinienwert für den gleichen Betriebszustand hingegen einen zweiten vorgegebenen Grenzwert, der höher ist als der erste Grenzwert, erkennt die Hauptsteuerung 26, dass die Kühlwirkung der Luftkühlvorrichtung 18 für den Wechselrichter 14 nicht mehr ausreicht. Die Hauptsteuerung 26 veranlasst dann als Schutzmaßnahme ein Abschalten der Antriebsschaltung 10.

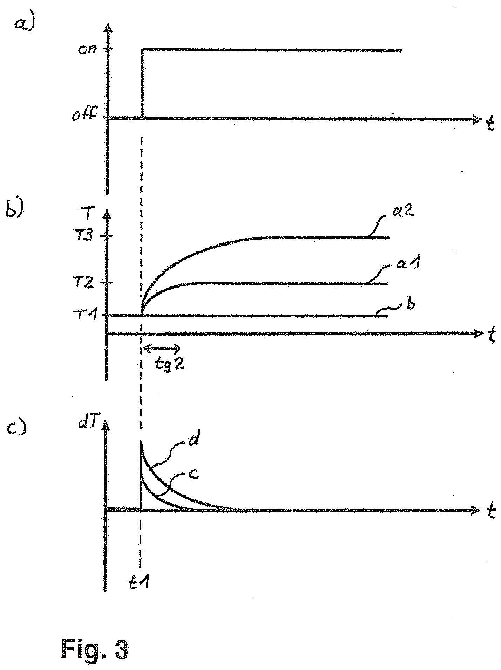

Die Überwachung der Kühlwirkung der Luftkühlvorrichtung 18 für den Wechselrichter kann alternativ auch anhand eines dynamischen Verhaltens der Kühlwirkung erfolgen, wie nun bezugnehmend auf Fig. 3 näher erläutert wird.

Fig. 3 zeigt mehrere Zeitdiagramme zum Veranschaulichen der Bauteiltemperatur TB und eines Temperaturgradienten dT für verschiedene Betriebszustände der Antriebsschaltung 10.

Die Teilfigur 3a zeigt analog zu Teilfigur 2a beispielhaft einen zeitlichen Verlauf des Betriebszustands der Antriebsschaltung 10. Zu einem Zeitpunkt t1 wird die Antriebsschaltung 10 durch die Baugruppensteuerung 16 eingeschaltet.

Die Teilfigur 3b zeigt beispielhaft einen zeitlichen Verlauf der Bauteiltemperatur TB für den Fall einer normalen Kühlwirkung (Kurve a1) und den Fall einer reduzierten Kühlwirkung (Kurve a2) sowie der Umgebungstemperatur TU (Kurve b). Die Umgebungstemperatur TU ist unabhängig von den Betriebszuständen der Antriebsschaltung 10 und des Lüfters 20 im Wesentlichen konstant. Solange die Antriebsschaltung 10 und der Lüfter 20 außer Betrieb sind, d.h. bis zum Zeitpunkt t1, hat die Bauteiltemperatur TB im Wesentlichen den gleichen Temperaturwert T1 wie die Umgebungstemperatur TU. Bei einer normalen Kühlwirkung einer fehlerfrei funktionierenden Luftkühlvorrichtung 18 steigt die Bauteiltemperatur TB nach dem Einschalten der Antriebsschaltung 10 und des Lüfters 20 zum Zeitpunkt t1 leicht an und pegelt sich nach kurzer Zeit auf einen im Wesentlichen konstanten Temperaturwert T2 ein. Bei einer reduzierten Kühlwirkung der Luftkühlvorrichtung 18 zum Beispiel wegen einer Verschmutzung oder Materialalterung steigt die Bauteiltemperatur TB nach dem Einschalten der Antriebsschaltung 10 und des Lüfters 20 zum Zeitpunkt t1 hingegen stärker an und pegelt sich nach kurzer Zeit auf einen im Wesentlichen konstanten Temperaturwert T3 ein, der höher als der Temperaturwert T2 ist.

Die Teilfigur 3c zeigt beispielhaft den Temperaturgradienten dT der Kurve a1 von Teilfigur 3b für den Fall einer normalen Kühlwirkung (Kurve c) und den Temperaturgradienten dT der Kurve a2 für den Fall einer reduzierten Kühlwirkung (Kurve d). Wie in Teilfigur 3c erkennbar, ist der Temperaturgradient dT im Fall einer reduzierten Kühlwirkung (Kurve d) kurz, d.h. bis zu einer zweiten vorbestimmten Zeitdauer tg2 nach dem Einschalten der Antriebsschaltung 10 und des Lüfters 20 deutlich größer als der Temperaturgradient dT im Fall einer normalen Kühlwirkung (Kurve c).

Basierend auf dieser Erkenntnis des Temperaturverhaltens kann die Hauptsteuerung 26 die Kühlwirkung der Luftkühlvorrichtung 18 für den Wechselrichter 14 überwachen. Hierzu werden die Umgebungstemperatur TU und die Bauteiltemperatur TB bis zu einer zweiten vorbestimmten Zeitdauer tg2 nach dem Zeitpunkt t1 des Einschaltens der Antriebsschaltung 10 und des Lüfters 20, d.h. kurz nach dem Einschalten der Antriebsschaltung 10 (Lastsprung) erfasst. Aus den zeitlichen Verläufen der beiden erfassten Temperaturwerte TB, TU wird dann der Temperaturgradient dT bestimmt. Überschreitet der Temperaturgradient dT einen vorgegebenen ersten Grenzwert, erkennt die Hauptsteuerung 26, dass die Kühlwirkung der Luftkühlvorrichtung 18 für den Wechselrichter 14 zwar noch ausreicht, aber deutlich reduziert ist. Die Hauptsteuerung 26 gibt dann ein entsprechendes Warnsignal an die Eingabe/Ausgabevorrichtung 30, um einen entsprechenden Wartungsvorgang einleiten zu lassen. Überschreitet der Temperaturgradient dT hingegen einen zweiten vorgegebenen Grenzwert, der höher ist als der erste Grenzwert, erkennt die Hauptsteuerung 26, dass die Kühlwirkung der Luftkühlvorrichtung 18 für den Wechselrichter 14 nicht mehr ausreicht. Die Hauptsteuerung 26 veranlasst dann als Schutzmaßnahme ein Abschalten der Antriebsschaltung 10.

### BEZUGSZIFFERNLISTE

- 10: Elektronikbaugruppe (z.B. Antriebsschaltung)
- 12: Motor
- 14: elektrisches Bauteil (z.B. Wechselrichter)
- 16: Baugruppensteuerung
- 18: Luftkühlvorrichtung
- 19: Kühlkörper
- 20: Lüfter
- 22: erster Temperatursensor
- 24: zweiter Temperatursensor
- 26: Hauptsteuerung
- 27: Timer
- 28: Speicher
- 30: Eingabe/Ausgabevorrichtung

- TB: Bauteiltemperatur
- TU: Umgebungstemperatur
- ΔT: Temperaturdifferenz
- dT: Temperaturgradient
- tg1: erste Zeitdauer nach Einschalten
- tg2: zweite Schaltdauer nach Einschalten

## Patentansprüche

1. Verfahren zum Überwachen einer Kühlwirkung einer Luftkühlvorrichtung (18) zum Kühlen eines elektrischen Bauteils (14) einer Elektronikbaugruppe (10), wobei die Luftkühlvorrichtung (18) einen mit dem Bauteil (14) thermisch gekoppelten Kühlkörper (19) und einen Lüfter (20) zum Erzeugen eines Kühlluftstroms über/durch den Kühlkörper (19) enthält, aufweisend:
Erfassen einer Bauteiltemperatur (TB) des elektrischen Bauteils (14);
Erfassen einer Umgebungstemperatur (TU) einer Umgebung der Elektronikbaugruppe (10); und
Ermitteln einer Kühlwirkung der Luftkühlvorrichtung (18) für das elektrische Bauteil (14) basierend auf der erfassten Bauteiltemperatur (TB), der erfassten Umgebungstemperatur (TU) und eines Betriebszustandes der Elektronikbaugruppe (10).

2. Verfahren nach Anspruch 1, bei welchem
das Verfahren ferner ein Bestimmen einer Temperaturdifferenz (ΔT) zwischen der erfassten Bauteiltemperatur (TB) und der erfassten Umgebungstemperatur (TU) aufweist; und
die Kühlwirkung der Luftkühlvorrichtung (18) basierend auf der bestimmten Temperaturdifferenz (ΔT) während eines stabilen Betriebszustandes der Elektronikbaugruppe (10) ermittelt wird.

3. Verfahren nach Anspruch 2, bei welchem
die Bauteiltemperatur (TB) und die Umgebungstemperatur (TU) nach einer ersten vorbestimmten Zeitdauer (tg1) nach einem Einschalten der Elektronikbaugruppe (10) erfasst werden.

4. Verfahren nach Anspruch 1, bei welchem
das Verfahren ferner ein Bestimmen eines Temperaturgradienten (dT) der erfassten Bauteiltemperatur (TB) aufweist; und
die Kühlwirkung der Luftkühlvorrichtung (18) basierend auf dem bestimmten Temperaturgradienten (dT) bei einem Lastsprung der Elektronikbaugruppe (10) ermittelt wird.

5. Verfahren nach Anspruch 4, bei welchem
die Bauteiltemperatur (TB) und die Umgebungstemperatur (TU) vor einer zweiten vorbestimmten Zeitdauer (tg2) nach einem Lastsprung der Elektronikbaugruppe (10) erfasst werden.

6. Verfahren nach einem der vorhergehenden Ansprüche, bei welchem
die bestimmte Temperaturdifferenz (ΔT) oder der bestimmte Temperaturgradient (dT) mit gespeicherten Kennlinien verglichen werden.

7. Verfahren nach einem der vorhergehenden Ansprüche, bei welchem
die Bauteiltemperatur (TB), die Umgebungstemperatur (TU), die Temperaturdifferenz (ΔT) und/oder der Temperaturgradient (dT) über mehrere Messungen hinweg gemittelt oder gefiltert werden.

8. Verfahren nach einem der vorhergehenden Ansprüche, bei welchem
beim Ermitteln einer Kühlwirkung der Luftkühlvorrichtung (18) zwischen einer reduzierten Kühlwirkung und einer unzureichenden Kühlwirkung differenziert wird.

9. Elektronische Anordnung mit einer Elektronikbaugruppe (10), die ein Wärme erzeugendes elektrisches Bauteil (14) enthält, und einer Luftkühlvorrichtung (18) zum Kühlen des elektrischen Bauteils (14), die einen mit dem Bauteil (14) thermisch gekoppelten Kühlkörper (19) und einen Lüfter (20) zum Erzeugen eines Kühlluftstroms über/durch den Kühlkörper (19) enthält, ferner aufweisend:
einen ersten Temperatursensor (22) zum Erfassen einer Bauteiltemperatur (TB) des elektrischen Bauteils (14);
eine Einrichtung (24) zum Erfassen einer Umgebungstemperatur (TU) einer Umgebung der Elektronikbaugruppe (10); und
eine Steuerung (16, 26) zum Ansteuern der Elektronikbaugruppe (10) und Ermitteln einer Kühlwirkung der Luftkühlvorrichtung (18) für das elektrische Bauteil (14) basierend auf der erfassten Bauteiltemperatur (TB), der erfassten Umgebungstemperatur (TU) und eines Betriebszustandes der Elektronikbaugruppe (10).

10. Elektrische Anordnung nach Anspruch 9, bei welcher
die Steuerung (16, 26) zum Ausführen des Verfahrens nach einem der Ansprüche 1 bis 8 ausgestaltet ist.

11. Elektrische Anordnung nach Anspruch 10, bei welcher
die Steuerung (16, 26) einen Timer (27) zum Erfassen einer Zeitdauer nach einem Einschalten der Elektronikbaugruppe (10) aufweist.

12. Elektrische Anordnung nach Anspruch 10 oder 11, bei welcher
die Steuerung (16, 16) einen Speicher (28) zum Speichern von Kennlinien für die Temperaturdifferenz (ΔT) und/oder Kennlinien für den Temperaturgradienten (dT) aufweist.
